# EUROPÄISCHE PATENTSCHRIFT

(11) **EP 1 668 173 B1**
(45) Veröffentlichungstag und Bekanntmachung des Hinweises auf die Patenterteilung: **15.12.2010**
(21) Anmeldenummer: 04786902.9
(22) Anmeldetag: 28.09.2004
(51) Int. Cl.: C25D 1/20, C23C 14/00, C30B 25/18, C25D 1/04

(54) **VERFAHREN UND HERSTELLUNGSANLAGE ZUM HERSTELLEN EINES SCHICHTARTIGEN BAUTEILS**
METHOD AND FACILITY FOR THE PRODUCTION OF A LAYER-LIKE PART
PROCEDE ET INSTALLATION DE PRODUCTION POUR PRODUIRE UN COMPOSANT STRATIFIE

(30) Priorität: 29.09.2003 DE 10346368
(43) Veröffentlichungstag der Anmeldung: 14.06.2006
(73) Patentinhaber: SIEMENS AKTIENGESELLSCHAFT, 80333 München (DE)
(72) Erfinder: HANSEN, Christian, 13156 Berlin (DE); KRÜGER, Ursus, 14089 Berlin (DE); PYRITZ, Uwe, 13599 Berlin (DE)
(86) Internationale Anmeldenummer: PCT/DE2004/002203
(87) Internationale Veröffentlichungsnummer: WO 2005/031043

(56) Entgegenhaltungen:
- WO-A-03/012166
- WO-A-03/012172
- US-A- 3 844 906
- US-A- 6 024 907
- GOODALL R ET AL: "FABRICATION OF CUBE-TEXTURED AG-BUFFERED NI SUBSTRATES BY ELECTRO-EPITAXIAL DEPOSITION" INTERNATIONAL JOURNAL OF INFRARED AND MILLIMETER WAVES, PLENUM PUBLISHING, NEW YORK, US, Bd. 14, 2001, Seiten 124-129, XP008042802 ISSN: 0195-9271

## Beschreibung

Die Erfindung betrifft ein Verfahren zum Herstellen eines schichtartigen Bauteils, bei dem das Bauteil auf einem Substratband durch Beschichten des Substrates erzeugt wird, wobei das Substrat aus einer Formgedächtnislegierung besteht, das mit dem Bauteil beschichtete Substrat derart temperiert wird, dass das Substrat eine Formänderung aufgrund des Formgedächtnisses erfährt und das Bauteil von dem Substratband getrennt wird.

Aus der US 6,024,907 ist ein Verfahren bekannt, bei dem eine Kunststofffolie mittels einer geeigneten Erzeugungseinrichtung hergestellt wird. Diese wird anschließend für eine Oberflächenbehandlung auf ein endloses Band aus einer Formgedächtnislegierung aufgebracht, wobei dieses Band eine geeignete Oberflächenstrukturierung aufweist. Das Aufbringen des Bandes erfolgt mittels zweier Druckwalzen. Um das strukturierte Band anschließend besser von dem Substratband lösen zu können, wird durch Erwärmung oder Abkühlung das Formgedächtnis des Substratbandes aktiviert, so dass die zwischen dem Substratband aufgrund seiner Formänderung und der Kunststofffolie auftretenden Spannungen die Ablösung der Kuststofffolie erleichtern.

Ein ähnliches Verfahren ist aus der US 4,530,739 bekannt. Bei dem Verfahren gemäß diesem Dokument wird ein schichtartiges Bauteil in Form eines endlosen Bandes auf einer als Substrat dienenden, sich drehenden Walze hergestellt. Zu diesem Zweck taucht die sich drehende Walze in ein galvanisches Bad ein, aus dem das herzustellende Bauteil auf der Walze abgeschieden wird. Sobald das schichtartige Bauteil die gewünschte Dicke erreicht hat, wird dieses von der Walze abgezogen und beispielsweise auf einer Vorratsrolle aufgewickelt.

Der Ablöseprozess des schichtartigen Bauteils von der Substratwalze wird durch eine Beheizung bzw. Kühlung des schichtartigen Bauteils und der Substratwalze unterstützt. Aufgrund der unterschiedlichen Wärmeausdehnungskoeffizienten der Substratwalze und des erzeugten schichtartigen Bauteils entsteht nämlich aufgrund verzerrungsbedingter Gitterspannungen in dem Gefüge der Substartwalze und des schichtartigen Bauteils entlang ihrer gemeinsamen Grenzfläche eine mechanische Spannung (im Folgenden auch als Stress bezeichnet), die die Bindungen der Atome in der Grenzfläche schwächt und so eine Trennung des schichtartigen Bauteils von der Substratwalze durch Abziehen erleichtert oder sogar bewirkt. Die Wirksamkeit der unterstützenden Wirkung einer Erwärmung oder Kühlung auf den Trennvorgang hängt vorrangig von dem Unterschied der Wärmeausdehnungskoeffizienten der Substratwalze und des schichtartigen Bauteils ab.

Die Aufgabe der Erfindung besteht darin, ein Verfahren zum Herstellen eines schichtartigen Bauteils auf einem Substrat anzugeben, bei dem eine Unterstützung der Trennung des schichtartigen Bauteils von dem Substrat durch einen Formgedächtniseffekt besonders vorteilbringend zur Anwendung kommen kann.

Diese Aufgabe wird erfindungsgemäß dadurch gelöst, dass die Gefügetextur des Substratbandes durch ein quasiepitaktisches Aufwachsen des schichtartigen Bauteils auf dieses übertragen wird. Anschließend wird die Formänderung des Substrates aufgrund seines Formgedächtnisses genutzt, um nach der Beschichtung des Substrates einen die Trennung von Substrat und Bauteil erleichternden Stress entlang der gemeinsamen Grenzfläche zwischen Substrat und Bauteil zu erzeugen. Der Formgedächtniseffekt kann beispielsweise bewirken, dass sich ein Substratband, auf dem das Bauteil erzeugt wurde, entlang seiner Längsausdehnung zusammenzieht, wobei die aufgrund der Haftung zwischen Substrat und Bauteil entstehenden Gitterverzerrungen entlang der Grenzfläche den Stress bewirken. Der Stress führt dann vorteilhaft zu einer Verringerung der Abziehkräfte für das Bauteil vom Substrat oder sogar schon zu dessen Trennung, so dass ein Abziehen im Wesentlichen kräftefrei erfolgen kann.

Das Verfahren kann erfindungsgemäß nun zum quasiepiktaktischen Aufwachsen von schichtartigen Bauteilen auf ein Substrat und deren anschließende Ablösung genutzt werden. Bei dem quasiepiktaktischen Aufwachsen wird eine Textur des Substratgefüges auf das aufwachsende, schichtartige Bauteil übertragen, so dass dieses dieselbe Gefügetextur aufweist. Das quasiepiktaktische Aufwachsen kann beispielsweise mittels PVD-Verfahren oder auch durch galvanische Abscheidung erfolgen. Vorteilhaft lassen sich auf diese Weise beispielsweise Hochtemperatursupraleiter (HTSL) wie YBa₂Cu₃O₇ (YBCO) oder auch zur Abscheidung solcher HTSL geeignete Substrate mit texturierter Gefügestruktur kostengünstig herstellen. Ein Verfahren zum quasiepiktaktischen Aufwachsen von HTSL-Schichten ist beispielsweise in der DE 101 36 890 A1 beschrieben.

Für die Trennung von quasiepiktaktisch aufgewachsenen, schichtförmigen Bauteilen vom Substrat lässt sich das erfindungsgemäße Verfahren, bei dem die Trennung durch den erzeugten Stress an der Grenzfläche zwischen Substrat und Bauteil erleichtert wird, besonders vorteilbringend anwenden. Aufgrund des Herstellungsprozesses, bei dem die Gefügetextur vom Substrat auf das schichtartige Bauteil übertragen wird, ist nämlich auch die Haftung zwischen dem Substrat und dem erzeugten Bauteil besonders groß, da die Gefüge von Bauteil und Substrat sozusagen wie der Schlüssel zum Schloss passen. Daher ist eine Verringerung der Haftung zwischen den beiden zu trennenden Partnern durch Aufbau eines Stresses im Gefüge notwendige Voraussetzung dafür, dass insbesondere dünne schichtartige Bauteile überhaupt vom Substrat abgezogen werden können. Weiterhin soll die die Grenzfläche zum Substrat bildende Oberfläche des schichtartigen Bauteils einerseits wie auch die Substratoberfläche andererseits nach dem Trennungsprozess möglichst defektfrei die Gefügetextur abbilden, damit zum Beispiel das Substrat mehrfach zum quasiepiktaktischen Aufwachsen verwendet werden kann bzw. das schichtartige Bauteil selbst ebenfalls als Substrat für einen weiteren Produktionsschritt des quasiepiktaktischen Aufwachsens Verwendung finden kann. Diese zumindest weitgehende Defektfreiheit der Oberfläche lässt sich nur erreichen, wenn die Trennung durch Ausbildung eines Stresses nach dem erfindungsgemäßen Verfahren unterstützt wird.

Gemäß einer ersten Ausgestaltung der Erfindung ist vorgesehen, dass bei dem Substrat der Einwegeffekt ausgenutzt wird, indem das Substrat vor der Beschichtung verformt wird und nach der Beschichtung derart erwärmt wird, dass das Substrat in seine unverformte Gestalt übergeht. Bei dem Einwegeffekt von Formgedächtnislegierungen wird der Umstand ausgenutzt, dass sich diese in einem bestimmten Temperaturbereich pseudoplastisch verformen lassen, d. h. dass sich diese pseudoplastische Verformung beim Verlassen dieses Temperaturbereichs durch Erwärmung zurückbildet und das Bauteil aus der Formgedächtnislegierung in seine ursprünglich unverformte Gestalt zurückfindet. Wird bei dem Verfahren z. B. ein Substratband verwendet, kann dieses vorteilhaft mit einfachen Mitteln gestreckt werden, anschließend beschichtet werden und unter Ausnutzung des Einwegeffektes, also einer Kontraktion des Bandes die Beschichtung vom Substratband gelöst werden. Auf diese Weise lassen sich vorteilhaft Substrate, insbesondere Substratbänder mit gut vorhersagbaren Eigenschaften hinsichtlich des Formgedächtniseffektes erzeugen, welche außerdem eine vergleichsweise hohe Zahl von Produktionszyklen der Banderzeugung auf dem Substratband ertragen können.

Gemäß einer zweiten Ausgestaltung der Erfindung ist vorgesehen, dass bei dem Substrat der Zweiwegeffekt ausgenutzt wird, indem das Substrat vor der Beschichtung derart temperiert wird, dass es in seine eine Gestalt übergeht und dass das Substrat nach der Beschichtung derart temperiert wird, dass es in seine andere Gestalt übergeht. Der Zweiwegeffekt von Formgedächtnislegierungen kann nur ausgenutzt werden, wenn das Bauteil mit dem Formgedächtniseffekt zunächst einer speziellen Behandlung, dem so genannten Training, unterworfen wird. Dabei werden nach dem gängigsten Verfahren in dem Bauteil gezielt irreversible Verformungen erzeugt, welche in dem Gefüge der Formgedächtnislegierung zur Ausbildung von spannungsinduzierenden Gefügefehlern führt. Diese Gefügespannungen bilden sich nach Durchlaufen mehrerer Trainingszyklen anisotrop im Gefüge aus und bewirken durch die Anisotropie den Zweiwegeffekt. Bei Erwärmung des Bauteils aus der Formgedächtnislegierung findet diese nach dem bereits beschriebenen Einwegeffekt in die Gestalt mit dem durch das Training erzeugten irreversiblen Verformungsanteil. Wird das Bauteil abgekühlt, findet das Bauteil aufgrund der durch das Training erzeugten charakteristischen Spannungsverteilung im Bauteil in den antrainierten Verformungszustand zurück. Durch abwechselnde Erwärmung und Abkühlung des Bauteils lässt sich dieser Vorgang wiederholen.

Für das Verfahren zum Herstellen des schichtartigen Bauteils eignet sich der Zweiwegeffekt vorteilhaft, um eine Ablösung aufgrund des Formgedächtniseffektes allein durch eine geeignete Temperaturführung des Prozesses (d. h. Erwärmen und Abkühlen in die notwendigen Temperaturbereiche) zu unterstützen. Dabei ist es besonders vorteilhaft, wenn das Substrat nach der Beschichtung abwechselnd derart erwärmt und abgekühlt wird, dass es abwechselnd in seine eine und in seine andere Gestalt übergeht. Durch die mehrfache Gestaltänderung des Substrates kann ein Ablöseprozess zwischen Substrat und Bauteil in mehreren Schritten erfolgen, d. h. eine vollständige oder zumindest zum Abziehen ausreichende Ablösung muss nicht bereits bei der ersten formgedächtnisbedingten Gestaltänderung des Substrates erfolgen.

Weiterhin bezieht sich die Erfindung auf eine Herstellungsanlage mit einem Substratband zur Herstellung eines bandförmigen, schichtartigen Bauteils, wobei das Substratband durch eine Erzeugungseinrichtung für das Bauteil und eine temperierbare Trenneinrichtung zur Gewinnung des Bauteils geführt ist und wobei das Substratband aus einer Formgedächtnislegierung besteht. Eine solche Trenneinrichtung ist in der eingangs bereits erwähnten US 6,024,907 beschrieben. Die Funktionsweise dieser Trenneinrichtung ist eingangs bereits genau erläutert worden.

Die Aufgabe der Erfindung besteht darin, eine Trenneinrichtung für ein auf einem Substrat befindliches Bauteil anzugeben, mit dem eine Unterstützung der Trennung des schichtartigen Bauteils vom Substrat durch einen Formgedächtniseffekt besonders vorteilhaft zur Anwendung kommen kann.

Diese Aufgabe wird erfindungsgemäß dadurch gelöst, dass die Erzeugungseinrichtung zum quasiepitaktischen Aufwachsen des schichtartigen Bauteils auf das Substrat vorgesehen ist und aus einer Anlage zum PVD-Beschichten oder zum galvanischen Abscheiden besteht. Damit kann die temperierte Trenneinrichtung dazu verwendet werden, die Trennung zwischen Substratband und schichtartigem Bauteil unter Ausnutzung des Formgedächtniseffektes zu unterstützen. Hierdurch lässt sich vorteilhaft das erzeugt Bauteil besonders schonend von dem Substratband lösen. Dass der Formgedächtniseffekt des Substratbandes für eine Trennung quasiepitaktich auf das Substrat aufgewachsener Bauteile genutzt werden kann und welche Vorteile sich daraus ergeben, ist bereits im Zusammenhang mit dem erfindungsgemäßen Verfahren genau erläutert worden.

Selbstverständlich kann eine Trennung von Substrat und schichtartigem Bauteil durch weitere Effekte zusätzlich erleichtert werden. Beispielsweise führt eine Abkühlung oder Beheizung von Substrat und Bauteil, wie in der eingangs erwähnten US 4,530,739 beschrieben, bei Vorliegen unterschiedlicher Wärmeausdehnungskoeffizienten zur Ausbildung eines zusätzlichen Stresses, der dem Stress aufgrund des Formgedächtnisses verstärkend überlagert werden kann. Gemäß einer anderen Möglichkeit kann unter der Voraussetzung, dass zumindest einer der Partner (Substratband oder Bauteil) ferromagnetisch ist, der Effekt der Magnetostrektion ausgenutzt werden. Zu diesem Zweck wird das mit dem schichtartigen Bauteil versehene Substrat einem Magnetfeld ausgesetzt, welches aufgrund des Effektes der Magnetostrektion zu einer Formänderung des ferromagnetischen Partners führt. Dies bewirkt bei geeigneter Ausrichtung des Magnetfeldes die Ausbildung eines zusätzlichen Stresses in der Grenzfläche zwischen dem Substrat und dem Bauteil.

Gemäß einer Ausgestaltung der Erfindung ist vorgesehen, dass der Erzeugereinrichtung eine Verformungseinrichtung, insbesondere eine Streckeinrichtung für das Substratband vorgeschaltet ist. Mit der Verformungseinrichtung lässt sich vorteilhaft der Einwegeffekt für das Substrat nutzen, indem dieses mittels der Verformungseinrichtung beispielsweise gestreckt wird, anschließend in der Erzeugungseinrichtung mit dem schichtartigen Bauteil beschichtet wird und dieses Bauteil unter Ausnutzung des Einwegeffektes aufgrund einer Erwärmung des Substrates von dem Substrat abgezogen wird. Alle für das erfindungsgemäße Verfahren wesentlichen Schritte lassen sich vorteilhaft in der Herstellungsanlage vereinen.

Eine andere Ausgestaltung der Erfindung sieht vor, dass der Erzeugungseinrichtung eine Temperiereinrichtung für das Substratband vorgeschaltet ist. Die Temperiereinrichtung kann vorteilhaft zur Ausnutzung eines "dem Substrat antrainierten" Zweiwegeffektes verwendet werden.

Eine letzte Ausgestaltung der Erfindung sieht vor, dass das Substratband als in der Herstellungsanlage umlaufendes Endlosband ausgeführt ist. Hierdurch lässt sich vorteilhafterweise der Prozess besonders effizient durchführen, weswegen sich die Herstellungsanlage für eine großtechnische Anwendung eignet.

Weitere Einzelheiten der Erfindung werden im Folgenden anhand der Zeichnung beschrieben. Hierbei zeigen
- Figur 1: schematisch eine Herstellungsanlage zur Herstellung eines schichtartigen Bauteils und dessen anschlie- ßenden Ablösung von einem umlaufenden Substratband,
- Figur 2: schematisch die Gefügeumwandlung α→β→α, die den Formgedächtniseffekt bedingt, in Abhängigkeit von der Temperatur T.

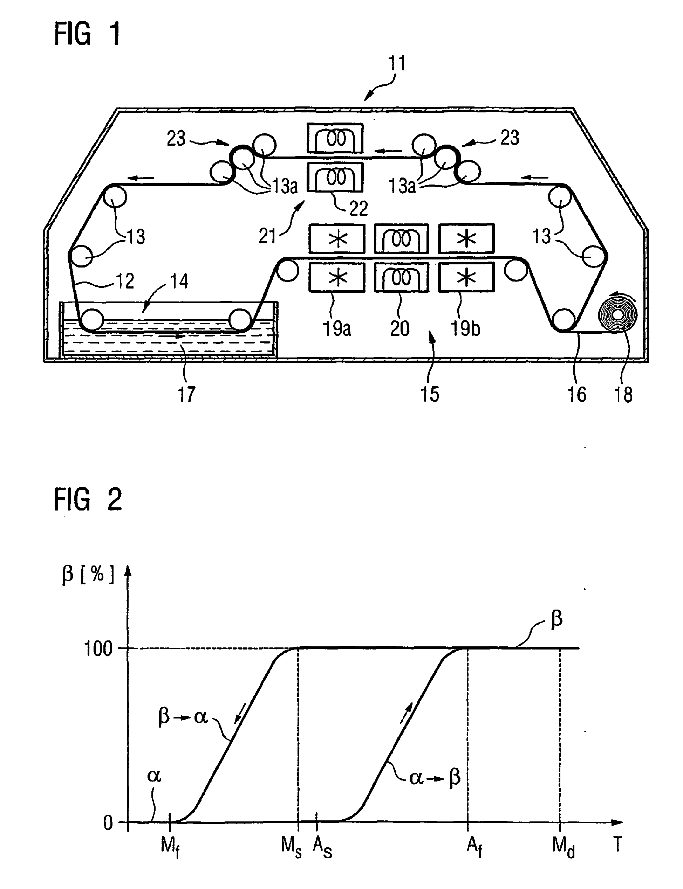

In Figur 1 ist eine Herstellungsanlage 11 dargestellt, in der ein Substratband 12 von Transportwalzen 13 geführt und angetrieben wird. Dieses Substratband 12 ist als Endlosband ausgeführt und läuft in der Herstellungsanlage entsprechend der angedeuteten Pfeile um. Die Herstellungsanlage weist eine Herstellungseinrichtung 14 und eine Trenneinrichtung 15 für ein schichtartiges Bauteil in Form eines Bandes 16 auf, wobei durch das Substratband 12 ein Transportweg durch die Herstellungsanlage 11 definiert ist, welcher durch die Herstellungseinrichtung 14 und die Trenneinrichtung 15 läuft.

Die Herstellungseinrichtung 14 ist durch ein galvanisches Bad 17 gebildet, in dem das Band 16 quasiepiktaktisch aufwächst, d. h. dass die Gefügetextur des Substratbandes auf das im galvanischen Bad durch Beschichten des Substratbandes 12 hergestellte Band 16 übertragen wird. Anschließend wird das mit dem Band 16 beschichtete Substratband 12 durch die Trenneinrichtung 15 geführt, in der die Haftung zwischen dem Substratband 12 und dem hergestellten Band 16 vermindert oder sogar vollständig aufgehoben wird, so dass das Band 16 von dem Substratband 12 abgezogen und auf eine Vorratsrolle 18 aufgewickelt werden kann. Das Substratband 12 wird nach dem Abziehen des Bandes 16 als Endlosschleife wieder zurück in das galvanische Bad 17 geführt.

In der Trenneinrichtung 15 durchläuft das Band 16 nacheinander einen Kühler 19a, eine Heizung 20 und einen weiteren Kühler 19b. Durch eine geeignete Kühlung und Beheizung in der Trenneinrichtung wird die Trennung des Substratbandes hervorgerufen. Während der Rückführung des Substratbandes 12 von der Trenneinrichtung 15 zum galvanischen Bad 17 durchläuft dieses weiterhin eine Konditioniereinrichtung 21, welche zur geeigneten Vorbereitung des Substratbandes für die Beschichtung dient, so dass nach der Beschichtung in der Trenneinrichtung der Formgedächtniseffekt zur Unterstützung bzw. Bewirkung der Trennung genutzt werden kann. Die Konditioniereinrichtung weist einerseits eine Heizung 22 auf, sowie weiterhin eine Streckeinrichtung 23, die aus besonderen, jeweils aufeinander abrollenden Transportwalzen 13a besteht. Zwischen den aufeinander abrollenden Transportwalzen 13a ist das Substratband geführt, so dass durch den Andruck jeweils benachbarter Transportwalzen 13a ein Rutschen auf des Substratbandes 12 auf diesen verhindert wird. Eine Streckung des Bandes wird dadurch erzielt, dass die Transportwalzen 13a hinter der Heizung 22 mit höherer Geschwindigkeit laufen, als die Transportwalzen 13a vor der Heizung.

Je nach genutztem Formgedächtniseffekt werden die Trenneinrichtung 14 und die Konditioniereinrichtung 21 in unterschiedlichen, aufeinander abgestimmten Funktionszuständen beschrieben. Bei der Nutzung des Einwegeffektes ist eine Beheizung durch die Heizung 22 nicht notwendig, sondern die Streckeinrichtung 23 kommt zum Einsatz, um eine Verformung des Substratbandes 12 zu erzeugen. Nach Durchlaufen des galvanischen Bades 17 muss somit lediglich durch Beheizung über die Heizung 20 in der Trenneinrichtung sichergestellt werden, dass das Substratband unter Ausnutzung des Formgedächtnisses in die ungestreckte Form übergeht.

Wird der Zweiwegeffekt genutzt, so ist die Streckeneinrichtung 23 durch Synchronisierung der Drehzahlen aller Transportwalzen 13a außer Kraft gesetzt. Dafür erfolgt eine Beheizung durch die Heizung 22, die den Formgedächtniseffekt in dem Substratband in die eine Richtung auslöst. Nach Durchlaufen des galvanischen Bades 17 kann durch Einsatz zumindest des Kühlers 19a der Formgedächtniseffekt zumindest einmal in die anderen Richtung aktiviert werden. Durch Einsatz der Heizung 20 und des Kühlers 19b wird der Zyklus des Zweiwegeffektes ein zweites Mal durchlaufen, wodurch eine stärkere Verringerung der Bindungskräfte zwischen Substratband 12 und Band 16 erreicht wird. Eine weitere Möglichkeit zur Nutzung des Zweiwegeffektes besteht darin, die Kühler 19a, 19b und die Heizungen 20, 22 gegeneinander zu tauschen, wodurch der Zweiwegeffekt im Substratband gerade komplementär zum oben beschriebenen Ablauf genutzt wird.

In Figur 2 ist die in Formgedächtnislegierungen wie z. B. Ni-Ti ablaufende Phasenumwandlung, die den Formgedächtniseffekt bewirkt, dargestellt. Der Formgedächtniseffekt tritt in Legierungen auf, in denen eine thermoelastische martensitische Phasenumwandlung möglich ist. Die mit dem Formgedächtnis ausgestatteten Bauteile müssen ein einphasiges Gefüge aufweisen. In der Tieftemperaturphase liegt das Gefüge als Martensit α vor. Wird das Gefüge erwärmt, bildet sich oberhalb einer Austenit-Starttemperatur Aₛ nach und nach ein austenitisches Gefüge β aus, wobei oberhalb der Temperatur A_{f} (Austenit-Finish)zu 100% die β-Phase ausgebildet ist. Wird der Austenit nun abgekühlt, wandelt er sich innerhalb des Bereiches von Mₛ bis M_{f} (Martensit-Start bis Martensit-Finish) wieder in Martensit α um, wobei in dem beschriebenen Prozess eine Hysterese durchlaufen wird. In einem Temperaturbereich zwischen A_{f} und M_{d} zeigt das Bauteil pseudoelastisches Verhalten. Dies bedeutet, dass sich in dem austenischen Gefüge spannungsinduziert Martensit bilden kann, welches sich bei Wegfall der Spannungen wieder zurück bildet.

Unterhalb der Temperatur M_{f} verhält sich das Bauteil pseudoplastisch, d. h. das es zunächst bleibend verformt werden kann, wobei jedoch eine Erwärmung des Bauteils oberhalb A_{f} den Formgedächtniseffekt im Bauteil aktiviert, so dass sich dieses unter Ausnutzung des Einwegeffektes zurückverformt.

Der Zweiwegeffekt wird durch ein Training mit plastischer Verformung des Bauteils unterhalb von M_{f} mit irreversiblen Anteilen "antrainiert". Zur Nutzung des Zweiwegeffektes wird das Bauteil abwechselnd unterhalb von M_{f} und oberhalb von A_{f} erwärmt und abgekühlt und wechselt dabei reversibel zwischen zwei Gestalten.

## Patentansprüche

1. Verfahren zum Herstellen eines schichtartigen Bauteils (16), bei dem
- das Bauteil (16) auf einem Substrat (12) durch Beschichten des Substrates (12) erzeugt wird, wobei das Substrat (12) aus einer Formgedächtnislegierung besteht,
- das mit dem Bauteil (16) beschichtete Substrat (12) derart temperiert wird, dass das Substrat eine Formänderung aufgrund des Formgedächtniseffektes erfährt und
- das Bauteil (16) von dem Substratband (12) getrennt wird,
**dadurch gekennzeichnet,**
**dass** die Gefügetextur des Substratbandes durch ein quasiepitaktisches Aufwachsen des schichtartigen Bauteils auf dieses übertragen wird.

2. Verfahren nach Anspruch 1,
**dadurch gekennzeichnet,**
**dass** bei dem Substrat (12) der Einwegeffekt ausgenutzt wird, indem das Substrat vor der Beschichtung verformt wird und nach der Beschichtung derart erwärmt wird, dass das Substrat in seine unverformte Gestalt übergeht.

3. Verfahren nach Anspruch 1,
**dadurch gekennzeichnet,**
**dass** bei dem Substrat (12) der Zweiwegeffekt ausgenutzt wird, indem das Substrat vor der Beschichtung derart temperiert wird, dass es in seine eine Gestalt übergeht und dass das Substrat nach der Beschichtung derart temperiert wird, dass es in seine andere Gestalt übergeht.

4. Verfahren nach Anspruch 3,
**dadurch gekennzeichnet,**
**dass** das Substrat (12) nach der Beschichtung abwechselnd derart erwärmt und abgekühlt wird, dass es abwechselnd in seine eine und in seine andere Gestalt übergeht.

5. Herstellungsanlage mit einem Substratband (12) zur Herstellung eines bandförmigen, schichtartigen Bauteils (16), wobei das Substratband (12) durch eine Erzeugungseinrichtung (17) für das Bauteil und eine temperierbare Trenneinrichtung (15) zur Gewinnung des Bauteils geführt ist und wobei das Substratband aus einer Formgedächtnislegierung besteht,
**dadurch gekennzeichnet,**
**dass** die Erzeugungseinrichtung eine Anlage zum quasiepitaktischen PVD-Beschichten oder zum quasiepitaktischen galvanischen Abscheiden ist.

6. Herstellungsanlage nach Anspruch 5,
**dadurch gekennzeichnet,**
**dass** der Erzeugungseinrichtung (17) eine Verformungseinrichtung, insbesondere eine Streckeinrichtung (23) für das Substratband vorgeschaltet ist.

7. Herstellungsanlage nach Anspruch 5 oder 6,
**dadurch gekennzeichnet,**
**dass** der Erzeugungseinrichtung (17) eine Temperiereinrichtung (22) für das Substratband vorgeschaltet ist.

8. Herstellungsanlage nach einem der Ansprüche 5 bis 8,
**dadurch gekennzeichnet,**
**dass** das Substratband (12) als in der Herstellungsanlage umlaufendes Endlosband ausgeführt ist.

## Claims

1. Method for producing a layer-like part (16) in which
- the part (16) is created on a substrate (12) by coating of the substrate (12), the substrate (12) consisting of a shape memory alloy,
- the substrate (12) coated with the part (16) is subjected to temperature control in such a way that the substrate undergoes a change in shape on account of the shape memory effect
- and the part (16) is separated from the substrate band (12),
**characterized in that** the microstructure texture of the substrate band is transferred to the layer-like part by the latter undergoing quasi-epitaxial growth.

2. Method according to Claim 1, **characterized in that**, in the case of the substrate (12), the one-way effect is used by the substrate being deformed before coating and heated after coating in such a way that the substrate goes over into its undeformed shape.

3. Method according to Claim 1, **characterized in that**, in the case of the substrate (12), the two-way effect is used by the substrate being subjected to temperature control before coating in such a way that it goes over into its one shape and the substrate being subjected to temperature control after coating in such a way that it goes over into its other shape.

4. Method according to Claim 3, **characterized in that** the substrate (12) is alternately heated and cooled after coating in such a way that it alternately goes over into its one shape and its other shape.

5. Production facility with a substrate band (12) for producing a layer-like part (16) in sheet form, the substrate band (12) being led through a creating device (17) for the part and a temperature-controllable separating device (15) to obtain the part, and the substrate band consisting of a shape memory alloy, **characterized in that** the creating device is a facility intended for quasi-epitaxial PVD coating or for quasi-epitaxial galvanic coating.

6. Production facility according to Claim 5, **characterized in that** the creating device (17) is preceded by a deforming device, in particular a stretching device (23), for the substrate band.

7. Production facility according to Claim 5 or 6, **characterized in that** the creating device (17) is preceded by a temperature-controlling device (22) for the substrate band.

8. Production facility according to one of Claims 5 to 7, **characterized in that** the substrate band (12) is configured as an endless belt circulating in the production facility.

## Revendications

1. Procédé de production d'un composant ( 16 ) stratifié, dans lequel
- on produit le composant ( 16 ) sur un substrat ( 12 ) en revêtant le substrat ( 12 ), le substrat ( 12 ) étant en un alliage à mémoire de forme,
- on met en température le substrat ( 12 ) revêtu du composant ( 16 ), de manière à ce que le substrat subisse une modification de forme, en raison de l'effet de mémoire et
- on sépare le composant ( 16 ) de la bande ( 12 ) de substrat,
**caractérisé**
**en ce que** l'on transfert au composant stratifié la texture de structure de la bande de substrat par une croissance quasi épitaxiale du composant stratifié.

2. Procédé suivant la revendication 1,
**caractérisé en ce que** l'on utilise pour le substrat ( 12 ) l'effet une fois en déformant le substrat avant le revêtement et en le réchauffant après le revêtement, de manière à ce que le substrat passe dans sa forme non déformée.

3. Procédé suivant la revendication 1,
**caractérisé en ce qu'**on utilise pour le substrat ( 12 ) l'effet deux fois, en mettant le substrat en température avant le revêtement, de manière à ce qu'il passe dans l'une de ses formes et en mettant le substrat en température après le revêtement, de manière à ce qu'il passe dans son autre forme.

4. Procédé suivant la revendication 3,
**caractérisé en ce que** l'on réchauffe et refroidit en alternance le substrat ( 12 ) après le revêtement, de manière à ce qu'il passe en alternance dans l'une de ses formes et dans son autre forme.

5. Installation de production comprenant une bande ( 12 ) de substrat pour la production d'un composant ( 16 ) stratifié en forme de bande, la bande ( 12 ) de substrat passant dans un dispositif ( 17 ) de production du composant et dans un dispositif ( 15 ) de séparation pouvant être mis en température en vue d'obtenir le composant et la bande de substrat étant en un alliage à mémoire de forme,
**caractérisé en ce que** le dispositif de production est une installation de revêtement PVD quasi épitaxial ou de dépôt galvanique quasi épitaxial.

6. Installation de production suivant la revendication 5,
**caractérisée en ce qu'**en amont du dispositif ( 17 ) de production est monté un dispositif de déformation, notamment un dispositif ( 23 ) d'étirage de la bande de substrat.

7. Installation de production suivant la revendication 5 ou 6,
**caractérisée en ce qu'**en amont du dispositif ( 17 ) de production est monté un dispositif ( 22 ) de mise en température de la bande du substrat.

8. Installation de production suivant l'une des revendications 5 à 7,
**caractérisé en ce que** la bande ( 12 ) de substrat est reliée sous la forme d'une bande sans fin tournant dans l'installation de production.
